# EUROPÄISCHE PATENTANMELDUNG

(11) **EP 1 439 573 A2**
(43) Veröffentlichungstag der Anmeldung: **21.07.2004**
(21) Anmeldenummer: 03030033.9
(22) Anmeldetag: 31.12.2003
(51) Int. Cl.: H01L 21/225

(54) **Verfahren zum Dotieren von Halbleiterkörpern**

(30) Priorität: 15.01.2003 DE 10301244
(71) Anmelder: Infineon Technologies AG, 81669 München (DE)
(72) Erfinder: Hofer, Heimo, 9586 Fürnitz (AT)
(74) Vertreter: Kindermann, Peter, Dipl.-Ing.

(57) **Zusammenfassung**

Die Erfindung betrifft ein Verfahren zum Dotieren von Halbleiterkörpern, wobei nach einem Erhöhen einer Temperatur einer Diffusionseinrichtung bis zu einem ersten Temperaturbereich (T_{I}) ein Belegen (Bel.I) der zu dotierenden Halbleiterkörper mit einem Dotierstoff erfolgt und nach einem weiteren Erhöhen der Temperatur bis zu einem zweiten Temperaturbereich (T_{II}) ein weiteres Belegen (Bel. II) der zu dotierenden Halbleiterkörper mit dem Dotierstoff und ein Eintreiben des Dotierstoffes in das Innere des Halbleiterkörpers durchgeführt wird, wodurch man eine wesentlich vergleichmäßigte Dotierstoff-Konzentrationsverteilung für den Halbleiterkörper erhält.

## Beschreibung

Die vorliegende Erfindung bezieht sich auf ein Verfahren zum Dotieren von Halbleiterkörpern und insbesondere auf ein Verfahren zum Eindiffundieren von Verunreinigungen bzw. Dotierstoffen in einen Halbleiterkörper aus der Gasphase.

Halbleiterkörper können kreisförmig, rechteckig, dreieckig oder in jeder anderen passenden Form vorhanden sein, haben jedoch typischerweise die Form eines Wafers bzw. einer Scheibe.

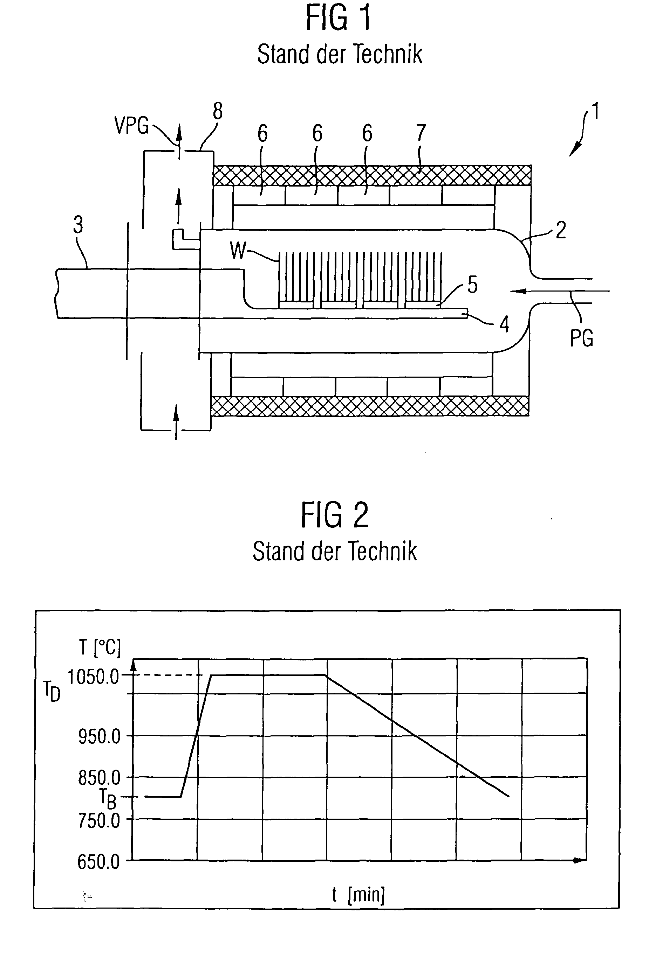

Figur 1 zeigt eine vereinfachte Schnittansicht eines horizontalen Diffusionsofens bzw. einer Diffusionseinrichtung 1, mit dem beispielsweise eine derartige Dotierung von Halbleiterkörpern durchgeführt werden kann.

Gemäß Figur 1 besteht der horizontale Diffusionsofen 1 aus einem SiC- (Siliziumcarbid) oder Quarzglasrohr 2 mit einer Einlassöffnung zum Einlassen von Prozessgas PG und einer Auslassöffnung zum Auslassen von verbrauchtem Prozessgas VPG. Mittels einer vorzugsweise automatischen Einfahrvorrichtung 3, die ein sogenanntes Paddle 4 zum Aufnehmen von einzelnen Booten 5 aufweist, können die Halbleiterkörper und vorzugsweise Halbleiterwafer W aufrecht stehend in das Quarzglasrohr 2 eingefahren und ausgefahren werden.

Zum Einstellen von für die Dotierung notwendigen Temperaturen bzw. Temperaturbereichen besitzt der Diffusionsofen 1 ferner Heizelemente 6, die beispielsweise radial um das Quarzglasrohr 2 in einem vorbestimmten Abstand angeordnet sind. Zur thermischen Isolierung der Heizelemente 6 sowie des Innenraums des Diffusionsofens 1 bzw. des Quarzglasrohrs 2 ist im Außenbereich eine thermische Isolation 7 vorgesehen. Ferner ist im Bereich der Auslassöffnung des Quarzglasrohres 2 eine Absaugvorrichtung 8 in Form einer durchströmten Kammer vorgesehen, wodurch die verbrauchten Prozessgase VPG abgesaugt werden können.

Ein nicht dargestellter Prozessrechner regelt hierbei eine Heizleistung der Heizelemente 6 in ihren jeweiligen Zonen, einen Volumenstrom sowie eine Zusammensetzung des Prozessgases PG sowie die automatische Einfahrvorrichtung 3.

Figur 2 zeigt eine vereinfachte graphische Darstellung eines Temperaturverlaufs gemäß dem Stand der Technik, wie er in dem gemäß Figur 1 dargestellten Diffusionsofen 1 zur Realisierung einer Dotierung der Halbleiterwafer W eingestellt werden kann. Im Wesentlichen wird hierbei nach dem Hochrampen bzw. Hochfahren einer Temperatur aus einem Bereitschafts-Temperaturbereich T_{B}, der beispielsweise 800 °C beträgt, unter Nicht-Dotiergasatmosphäre anschließend in einem Diffusions-Temperaturbereich T_{D}, der bei ca. 900 bis 1100 °C liegt, eine Dotierung am Halbleiterwafer durchgeführt, wobei Verunreinigungen bzw. Dotierstoffe in das Innere des Halbleiterkörpers eingebracht werden. Abschließend erfolgt gemäß Figur 2 wiederum ein Erniedrigen der Temperatur des Diffusionsofens 1 in den Bereitschafts-Temperaturbereich T_{B}.

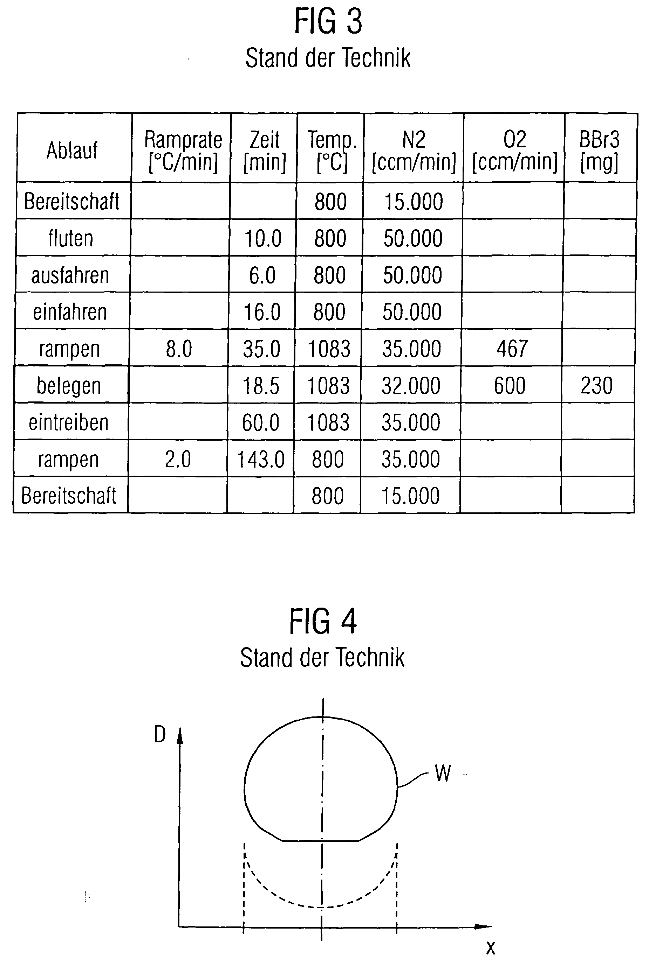

Figur 3 zeigt eine vereinfachte tabellarische Darstellung zur Veranschaulichung der wesentlichen Prozessparameter gemäß dieses herkömmlichen Verfahrens.

Gemäß Figur 3 befindet sich der Diffusionsofen 1 zunächst in einem Bereitschaftszustand, wobei ein Bereitschafts-Temperaturbereich T_{B} eine Temperatur von ca. 800 °C aufweist und als Prozessgas PG lediglich Stickstoff bzw. N₂ mit einem Gasfluss von 15000 ccm/min zugeführt wird. Vor einem Ausfahren von beispielsweise bereits dotierten Halbleiterwafern W wird gemäß Figur 3 beispielsweise für ca. 10 Minuten im Bereitschafts-Temperaturbereich die Quarzglasröhre 2 mit ca. 50000 ccm/min N₂ als Trägergas geflutet und anschließend werden mittels der automatischen Einfahrvorrichtung 3 die auf ihren Booten 5 platzierten Halbleiterwafer W innerhalb von 6 Minuten aus dem Quarzglasrohr 2 ausgefahren.

Nunmehr können neue zu dotierende Halbleiterkörper bzw. Halbleiterwafer W auf den Booten 5 bzw. dem Paddle 4 positioniert werden und bei unveränderten Temperatur- und Gasflussbedingungen wieder eingefahren werden (ca. 16 min).

Nach diesem Einfahren und beispielsweise dem Verschließen des Quarzglasrohrs 2 erfolgt nunmehr ein Erhöhen (Rampen) der Temperatur des Diffusionsofens 1 mit einer Rate von 8,0 °C pro Minute bis in den Diffusions-Temperaturbereich T_{D} bzw. bis auf eine Temperatur von ca. 1083 °C. Während dieses Rampens bzw. Hochfahrens der Temperatur für ca. 35 Minuten wird der Gasfluss des Trägergases N₂ auf 35000 ccm/min verringert und zur Ausbildung einer Oxidschicht an der Oberfläche der Halbleiterwafer W Sauerstoff bzw. O₂ mit beispielsweise 467 ccm/min als Reaktionsgas zugeführt. Die Oxidschicht dient hierbei als Ausgangsschicht zur Realisierung einer Dotierstoffquelle.

Nach dem Hochrampen bzw. Erhöhen der Temperatur in den Diffusions-Temperaturbereich T_{D} erfolgt nunmehr das Belegen der zu dotierenden Halbleiterwafer W mit einem Dotierstoff, wobei im Wesentlichen die beim Rampen ausgebildete Oxidschicht weiter ausgebildet und zugleich mit Dotierstoffen bzw. Verunreinigungen versehen wird. Üblicherweise wird hierfür der Gasfluss des Trägergases N₂ weiter auf 32000 ccm/min erniedrigt und der Gasfluss des Reaktionsgases O₂ auf 600 ccm/min erhöht, wobei zusätzlich dem Prozessgas PG als Dotierstoff BBr₃ mit 230 mg zugeführt wird. Nach diesem Ausbilden der Dotierstoffquelle bzw. der mit hoher Dotierstoffkonzentration angereicherten Oxidschicht erfolgt nunmehr das eigentliche Dotieren des Halbleiterkörpers, wobei gemäß Figur 3 bei im Wesentlichen unveränderter Temperatur und einer geringfügigen Erhöhung des Trägergases N₂ auf 35000 ccm/min die in der Oxidschicht vorhandenen Verunreinigungen bzw. Dotierstoffe in das Innere des Halbleiterkörpers eingetrieben werden. Dieser Vorgang dauert ca. 60 Minuten, wobei weder ein Reaktionsgas noch ein Dotierstoff im Prozessgas PG weiter zugeführt wird.

Nach diesem Eintreiben des Dotierstoffes in das Innere der Halbleiterwafer W erfolgt nunmehr ein Erniedrigen bzw. entgegengesetztes Rampen der Temperatur des Diffusionsofens 1 bis zum Bereitschafts-Temperaturbereich T_{B} wobei beispielsweise eine Rate von -2,0 °C /min bei unverändertem Träger-Gasfluss durchgeführt wird. Nach ca. 143 Minuten wird somit wieder der Bereitschaftszustand erreicht, bei dem der Gasfluss des Trägergases N₂ wieder auf 15000 ccm/min verringert wird. Auf diese Weise kann in den Silizium-Halbleiterwafern W eine Dotierung durchgeführt werden.

Nachteilig ist jedoch hierbei, dass ein derartiges herkömmliches Verfahren eine außerordentlich hohe Streuung von prozesstechnischen und ausbeuterelevanten elektrischen Parametern des Endproduktes hervorruft. Diese Streuung führt wiederum zu erhöhten Ausbeuteeinbußen insbesondere auf bestimmten Scheibenbereichen und bei ungünstigen Prozesskombinationen, woraus erhöhte Herstellungskosten resultieren.

Figur 4 zeigt eine vereinfachte Darstellung einer Dotierstoff-Konzentrationsverteilung D in Abhängigkeit von einem Ort x auf dem Halbleiterwafer W.

Gemäß Figur 4 besteht demzufolge bei herkömmlichen Prozessen ein Problem darin, dass das Prozessgas auf seinem Weg vom Scheibenrand zur Scheibenmitte hin bereits wesentlich an Dotierstoff verarmt, wodurch sich die in Figur 4 dargestellte stark gekrümmte Dotierstoff-Konzentrationsverteilung ergibt. Dieses liegt insbesondere an der Tatsache, dass der Waferrandbereich derartig gierig nach den im Prozessgas PG befindlichen Dotierstoffen ist, dass für einen später vom Prozessgas erreichten mittigen Bereich des Halbleiterwafers W der Dotierstoff nicht mehr in ausreichend hoher Konzentration übrig bleibt. Genauer gesagt ist in diesem Fall das Prozessgas PG unterhalb des Sättigungsniveaus des Halbleitermaterials und beispielsweise unterhalb des Sättigungsniveaus von Si für den jeweiligen Dotierstoff bei dieser Temperatur.

Andererseits hätte eine wesentliche Erhöhung des Dotierstoffanteils im Prozessgas PG negative Auswirkungen auf die Komponenten des Diffusionsofens, da beispielsweise eine Kondensation bzw. eine Auskristallisierung der Entstehungsprodukte, ein Verkleben der beweglichen Deckelteile usw. die Folge wäre.

Andererseits bedeutet eine Verringerung der Diffusions-Temperatur T_{D} einen erhöhten Zeitaufwand bei der Dotierung und somit einen nicht vertretbaren Kostennachteil.

Der Erfindung liegt daher die Aufgabe zu Grunde ein Verfahren zum Dotieren von Halbleiterkörpern zu schaffen, bei dem mit minimalen Kosten eine Dotierstoff-Konzentrationsverteilung im Halbleiterkörper vergleichmäßigt und somit eine Ausbeute wesentlich verbessert ist.

Erfindungsgemäß wird diese Aufgabe durch die Maßnahmen des Patentanspruchs 1 gelöst.

Insbesondere durch das Erhöhen einer Temperatur der Diffusionseinrichtung bis zu einem ersten Temperaturbereich, das Belegen der zu dotierenden Halbleiterkörper mit einem Dotierstoff bei dem ersten Temperaturbereich, das Erhöhen der Temperatur der Diffusionseinrichtung bis zu einem zweiten Temperaturbereich, das Belegen der zu dotierenden Halbleiterkörper mit dem Dotierstoff im zweiten Temperaturbereich und das Eintreiben des Dotierstoffes in das Innere des Halbleiterkörpers im oder oberhalb des zweiten Temperaturbereichs kann eine Dotierstoff-Konzentrationsverteilung im Halbleiterkörper in Abhängigkeit von einem jeweiligen Ort wesentlich vergleichmäßigt werden, wodurch sich Streuungen von prozesstechnischen und ausbeuterelevanten elektrischen Parametern wesentlich verringern lassen und sich eine erhöhte Ausbeute ergibt.

Vorzugsweise wird der erste Temperaturbereich um eine Temperaturdifferenz von mindestens 50 °C und vorzugsweise von ca. 200 °C unterhalb des zweiten Temperaturbereichs eingestellt, wodurch sich eine maximale Vergleichmäßigung der Dotierstoff-Konzentrationsverteilung bei minimal erhöhter Prozessdauer ergibt.

Vorzugsweise ist der erste Temperaturbereich größer 850 °C und vorzugsweise bei ca. 900 °C, während der zweite Temperaturbereich in einem Bereich von 900 bis 1100 °C und vorzugsweise bei ca. 1100 °C eingestellt wird, wodurch man insbesondere bei Verwendung von Silizium-Halbleitermaterial eine optimale Verteilung der Dotierstoffe über den Halbleiterkörper erhält.

Vorzugsweise wird beim Erhöhen der Temperatur und/oder beim Belegen zusätzlich eine Oxidation der Oberfläche der Halbleiterkörper in der Diffusionseinrichtung durchgeführt, wodurch eine Dotierung nicht unmittelbar aus der Gasphase sondern über eine dadurch entstehende Oxidationsschicht ermöglicht wird.

In den weiteren Unteransprüchen sind weitere vorteilhafte Ausgestaltungen der Erfindung gekennzeichnet.

Die Erfindung wird nachstehend anhand eines Ausführungsbeispiels unter Bezugnahme auf die Zeichnung näher beschrieben.

Es zeigen:
Figur 1 eine vereinfachte Schnittansicht eines herkömmlichen Diffusionsofens;
Figur 2 eine vereinfachte graphische Darstellung eines Temperaturverlaufs gemäß dem Stand der Technik;
Figur 3 eine tabellarische Darstellung zur Veranschaulichung wesentlicher Prozessschritte bei dem Dotierverfahren gemäß dem Stand der Technik;
Figur 4 eine vereinfachte graphische Darstellung einer Dotierstoff-Konzentrationsverteilung in Abhängigkeit von einem Ort auf dem Halbleiterwafer gemäß dem Stand der Technik;
Figur 5 eine vereinfachte graphische Darstellung eines erfindungsgemäßen Temperaturverlaufs;
Figur 6 eine tabellarische Darstellung zur Veranschaulichung wesentlicher Prozessschritte bei dem erfindungsgemäßen Dotierverfahren;
Figur 7 eine vereinfachte graphische Darstellung einer erfindungsgemäßen Dotierstoff-Konzentrationsverteilung in Abhängigkeit von einem Ort auf dem Halbleiterwafer; und
Figur 8 eine graphische Darstellung zur Veranschaulichung einer Veränderung der Dotierstoff-Konzentrationsverteilung in Abhängigkeit von verschiedenen Prozessstadien des erfindungsgemäßen Dotierverfahrens.

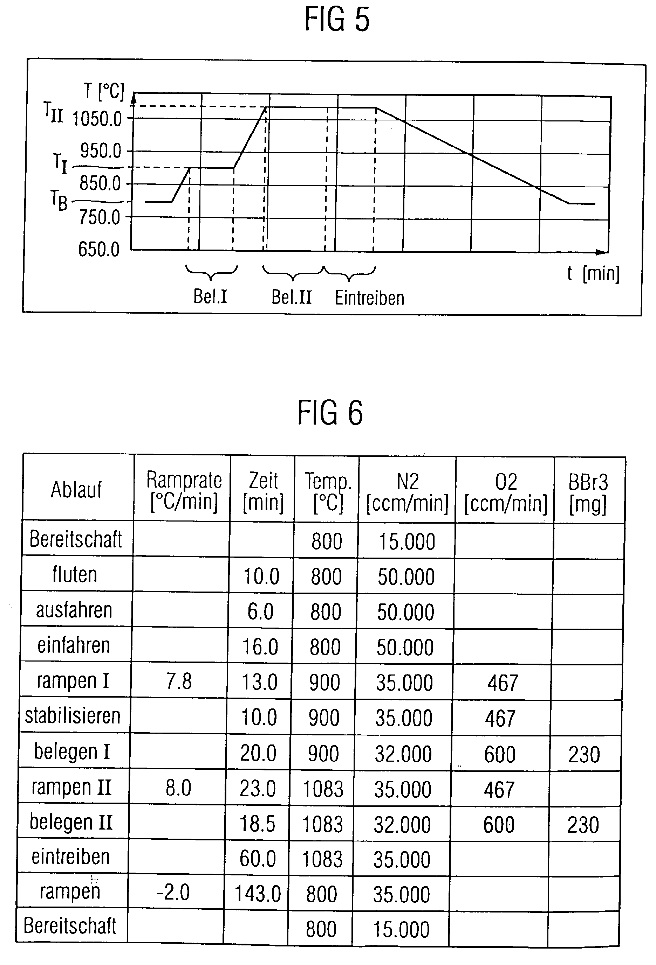

Figur 5 zeigt eine vereinfachte graphische Darstellung eines Temperaturverlaufs bei dem erfindungsgemäßen Verfahren, wobei im Wesentlichen eine Diffusionseinrichtung bzw. ein horizontaler Diffusionsofen verwendet wird, wie er in Figur 1 beschrieben wurde. Auf eine wiederholte Beschreibung dieser Diffusionseinrichtung bzw. dieses Diffusionsofens 1 wird daher nachfolgend verzichtet.

Im Gegensatz zum herkömmlichen Temperaturverlauf gemäß Figur 2 handelt es sich bei dem erfindungsgemäßen Temperaturverlauf gemäß Figur 5 um einen zweistufigen Prozess, wobei die Halbleiterkörper vorerst bei einem um eine Temperaturdifferenz von mindestens 50 °C unterhalb eines endgültigen zweiten Temperaturbereichs T_{II} niedrigeren ersten Temperaturbereich T_{I} eingestellt bzw. gebracht werden, um dort dem Dotiergas ausgesetzt zu werden.

Durch die niedrigere Temperatur ist erfindungsgemäß ein Rand des Halbleiterkörpers bzw. ein Waferrand nicht mehr so gierig nach dem Dotierstoff und lässt genügend hoch konzentriertes Prozessgas PG und somit Dotierstoff in ausreichend hoher Konzentration bis zur Mitte des Halbleiterkörpers bzw. bis zur Scheibenmitte des Wafers W vordringen. Das Prozessgas PG bleibt also mit seiner Konzentration an Dotierstoffen oberhalb der Aufnahmekapazität des Halbleiterkörpers bzw. Halbleiterwafers W, wodurch man eine sehr homogene Vordotierung des Halbleiterkörpers bzw. einer an der Oberfläche des Halbleiterkörpers ausgebildeten Dotierstoffquelle-Hilfsschicht erhält.

Nach dieser Vordotierung bzw. einem Belegen I des Halbleiterkörpers wird nun auf die endgültige Diffusionstemperatur bzw. in den zweiten Temperaturbereich T_{II} hochgeheizt, wodurch die eigentliche Dotierung auf einen geforderten Zielwiderstand erfolgt. Da der Wafer durch Vordotierung zumindest teilweise abgesättigt ist, lässt er jetzt auch das Prozessgas ohne dramatische Abreicherung in die Scheibenmitte vordringen, wobei die bereits angereicherte Oberfläche jetzt nurmehr "nachgefüttert" wird. Auf diese Weise lässt sich somit eine sehr gleichmäßige Dotierstoff-Konzentrationsverteilung und folglich sehr geringe Streuung von prozesstechnischen und ausbeuterelevanten elektrischen Parametern im Vergleich zum herkömmlichen Verfahren gemäß Figuren 2 bis 4 realisieren.

Figur 6 zeigt eine tabellarische Darstellung von wesentlichen Verfahrensschritten anhand eines bevorzugten Ausführungsbeispiels, wobei gleiche Begriffe oder Abkürzungen gleiche oder entsprechende Bedeutungen aufweisen wie in Figur 3 und auf eine wiederholte Beschreibung nachfolgend verzichtet wird.

In dem bevorzugten Ausführungsbeispiel gemäß Figur 6 werden wiederum beispielsweise Silizium-Halbleiterwafer W in einem horizontalen Diffusionsofen gemäß Figur 1 dotiert.

Hierbei liegt in einem Bereitschaftszustand ein Bereitschafts-Temperaturbereich T_{B} bei ca. 800 °C und ein Gasfluss des verwendeten N₂-Trägergases bei 15000 ccm/min. Zum Vorbereiten der Diffusionseinrichtung 1 bzw. des Diffusionsofens kann gemäß Figur 6 zunächst ein Fluten des Quarzglasrohres 2 mit dem N₂-Trägergas für ca. 10 Minuten bei einer Temperatur von 800 °C durchgeführt werden, wobei ein Gasfluss des Trägergases ca. 50000 ccm/min beträgt. Nach diesem Fluten können die beispielsweise bereits dotierten Halbleiterwafer W aus dem Diffusionsofen bzw. dem Quarzglasrohr 2 mittels der automatischen Einfahrvorrichtung ausgefahren werden, wobei die Prozessparameter hinsichtlich der Temperatur, und des N₂-Träger-Gasflusses unverändert bleiben. Dieser Vorgang dauert ca. 6 Minuten.

Nach dem Entnehmen der bereits dotierten Halbleiterwafer W aus den auf dem Paddle 4 befestigten Booten 5 werden diese vorzugsweise mit zu dotierenden Silizium-Halbleiterwafern W bestückt und erneut in den Diffusionsofen 1 bzw. das Quarzglasrohr 2 eingefahren. Dieses Einfahren erfolgt wiederum bei gleichen Temperatur- und Gasflussbedingungen und benötigt ca. 16 Minuten.

In einem nachfolgenden Prozessschritt erfolgt nunmehr ein Rampen I bzw. ein Erhöhen der Temperatur des Diffusionsofens 1 bis zu einem ersten Temperaturbereich T_{I}. Das Erhöhen der Temperatur in diesem Schritt wird beispielsweise mit einer Rate von ca. 8,0 °C /min durchgeführt und gemäß Figur 6 mit einer Rate von 7,8 Grad Celsius/min. Der Gasfluss des N₂-Trägergases wird hierbei auf ca. 35000 ccm/min verringert, wobei der erste Temperaturbereich T_{I} bei ca. 900 °C liegt.

Anschließend erfolgt für ca. 10 Minuten eine Stabilisierungsphase im ersten Temperaturbereich T_{I}, wobei der Gasfluss des N₂-Trägergases konstant gehalten wird.

Obwohl beim Erhöhen der Temperatur und beim Stabilisieren grundsätzlich keine Reaktionsgase benötigt werden, können zur Verbesserung des Dotierverfahrens mittels zusätzlicher Reaktionsgase Hilfsschichten an der Oberfläche der Halbleiterkörper bzw. -wafer W ausgebildet werden. Gemäß Figur 6 wird demzufolge ein O₂-Reaktionsgas dem N₂-Trägergas zugeführt, wodurch das Prozessgas PG nunmehr auch eine oxidierende Wirkung auf das Halbleitermaterial erhält. Bei Verwendung von Silizium-Halbleiterwafern wird dadurch während des Erhöhens der Temperatur auf den ersten Temperaturbereich T_{I} und dem Stabilisierungsschritt bereits eine dünne Siliziumdioxidschicht an der Oberfläche der Halbleiterwafer thermisch ausgebildet, die als Dotierstoffquelle-Hilfsschicht in späteren Verfahrensschritten verwendet werden kann.

Folglich wird in einem ersten Belegungsschritt I zum Belegen der zu dotierenden Halbleiterkörper mit einem Dotierstoff wie z.B. Bor im ersten Temperaturbereich T_{I} nunmehr ca. 230 mg BBr₃ dem Prozessgas zugeführt, welches ca. 32000 ccm/min N₂ und 600 ccm/min O₂ aufweist. Bei diesem ca. 20 Minuten dauernden Belegungsschritt I erfolgt eine sogenannte Vordotierung, wobei insbesondere bei Verwendung der Dotierstoffquelle-Hilfsschicht eine Einlagerung der Dotierstoffe, d.h. Bor, insbesondere in die Oxidschicht erfolgt, während der Halbleiterkörper im Wesentlichen noch undotiert bleibt. Alternativ kann auch Phosphor als Dotierstoff zum Einsatz kommen, wobei die Oxidschicht durch dessen Segregationsverhalten als Diffusionsbarriere wirkt. Hierbei kann ebenfalls das Eindiffundieren des Dotierstoffes vergleichmäßigt werden. Grundsätzlich kann jedoch das Ausbilden dieser Dotierstoffquelle-Hilfsschicht auch entfallen, wobei das Belegen bzw. das Einbringen der Dotierstoffe zunächst nur an der Oberfläche der Halbleiterkörper W erfolgt.

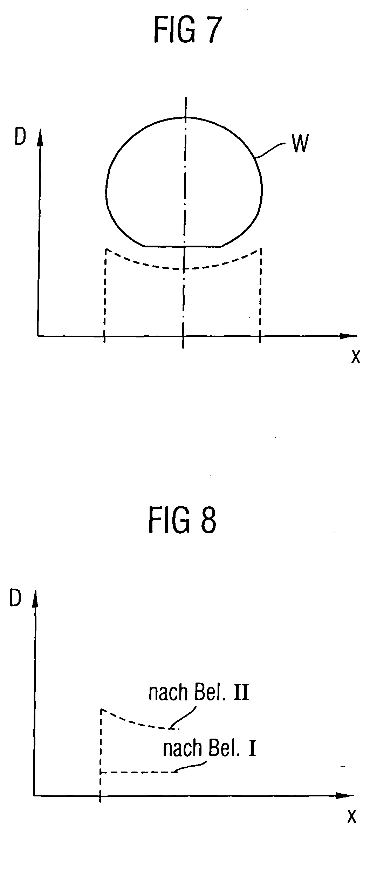

Da der erste Temperaturbereich T_{I} um mindestens 50 °C und vorzugsweise ca. 200 °C unterhalb des zweiten Temperaturbereichs T_{II} eingestellt wird, erhält man gemäß Figur 8 zunächst eine sehr geringe, jedoch über einen Ort des Halbleiterwafers W sehr gleichmäßig verlaufende Dotierstoff-Konzentrationsverteilung D.

Gemäß Figur 6 wird in einem nachfolgenden Verfahrensschritt ein erneutes Rampen II bzw. Erhöhen der Temperatur des Diffusionsofens 1 bis zu dem zweiten Temperaturbereich T_{II} wiederum unter Nicht-Dotiergasatmosphäre durchgeführt, wobei eine Rate von ca. 8,0 °C /min verwendet wird. Der zweite Temperaturbereich T_{II} liegt nunmehr bei ca. 1083 °C, wobei der Gasfluss für das Trägergas wiederum auf 35000 ccm/min angehoben und der Gasfluss des optional zu verwendenden Reaktionsgases O₂ auf 467 ccm/min reduziert wird. Auf diese Weise kann die optional verwendete Dotierstoffquelle-Hilfsschicht weiter ausgebildet werden.

In einem weiteren Verfahrensschritt erfolgt nunmehr das Belegen II der zu dotierenden Halbleiterkörper W bzw. der Dotierstoffquelle-Hilfsschicht mit dem Dotierstoff im zweiten Temperaturbereich T_{II}. Genauer gesagt wird nunmehr für eine Zeitdauer von ca. 18,5 Minuten dem Prozessgas PG wiederum 230 mg BBr₃ zugeführt, wobei das N₂-Trägergas auf 32000 ccm/min reduziert und das O₂-Reaktionsgas auf 600 ccm/min erhöht wird. Hierdurch wird eine weitergehende Belegung des zu dotierenden Halbleiterkörpers mit dem Dotierstoff und insbesondere eine Belegung der Hilfsschicht durchgeführt.

Nach diesem Belegen II erfolgt das eigentliche Eintreiben der Verunreinigungen in das Innere des Halbleiterkörpers bzw. - wafers W wiederum vorzugsweise im zweiten Temperaturbereich T_{II} (d.h. bei ca. 1083 °C), wobei jedoch das Reaktionsgas O₂ (d.h. bei ca. 1083 °C), wobei jedoch das Reaktionsgas O₂ sowie die Dotierstoffe aus dem Prozessgas entfernt werden und dieses lediglich das Trägergas mit einem Gasfluss von 35000 ccm/min aufweist. Grundsätzlich kann das Eintreiben auch bei noch höheren Temperaturen stattfinden.

Figur 8 zeigt eine erhöhte Dotierstoff-Konzentrationsverteilung D über einem Ort des Halbleiterwafers W nach einem Belegen II, die im Vergleich zur herkömmlichen Dotierstoff-Konzentrationsverteilung insbesondere zur Mitte des Halbleiterwafers W hin wesentlich vergleichmäßigt ist. Diese vergleichmäßigte Dotierstoff-Konzentration kann bei dem vorstehend beschriebenen Eintreibschritt nunmehr auch in das Innere des Halbleiterkörpers übertragen werden, wodurch sich wesentlich vergleichmäßigte Dotierstoff-Konzentrationen auch für das Innere des Halbleiterkörpers ergeben und somit eine Streuung von prozesstechnischen und ausbeuterelevanten elektrischen Parametern verringert und eine Ausbeute wesentlich erhöht ist.

Nach dem Eintreiben der Dotierstoffe in das Innere des Halbleiterkörpers erfolgt wiederum ein Rampen bzw. Erniedrigen der Temperatur des Diffusionsofens 1 bis zum Bereitschafts-Temperaturbereich T_{B}, d.h. bis ca. 800 °C, wobei vorzugsweise eine Rate von -2,0 °C/min und ein Träger-Gasfluss von 35000 ccm/min verwendet wird. Anschließend kann der Träger-Gasfluss wiederum auf den Bereitschaftszustand angesenkt werden, wobei ca. 15000 ccm/min N₂ durch das Quarzglasrohr 2 fließen.

Figur 7 zeigt eine vereinfachte graphische Darstellung einer Dotierstoff-Konzentrationsverteilung D in Abhängigkeit von einem Ort x eines zu dotierenden Halbleiterwafers W, wobei nach Durchführung des erfindungsgemäßen Dotierverfahrens eine wesentlich vergleichmäßigte Dotierstoff-Konzentrationsverteilung realisiert werden kann.

Obwohl im vorstehend beschriebenen Prozess eine ca. 600 nm dicke Oxidschicht als Dotierstoffquelle-Hilfsschicht ausgebildet wird, kann das Ausbilden dieser Schicht auch entfallen und lediglich eine Vordotierung in einem ersten Temperaturbereich T_{I} und eine endgültige Dotierung in einem zweiten Temperaturbereich T_{II} durchgeführt werden.

Ferner kann an Stelle des verwendeten Silizium-Halbleitermaterials auch jedes weitere Halbleitermaterial verwendet werden.

Obwohl beim vorstehend beschriebenen Verfahren als Trägergas N₂, als Reaktionsgas O₂ und als Dotierstoffmaterial BBr₃ verwendet wurde, können selbstverständlich auch andere Trägergas-, Reaktionsgas- und/oder Dotierstoffmaterialien zur Realisierung einer entsprechenden p- und/oder n-Dotierung verwendet werden.

In gleicher Weise können neben den vorgeschlagenen Temperaturbereichen auch alternative Temperaturbereiche in Abhängigkeit von jeweiligen Halbleitermaterialien und/oder Prozessgasen verwendet werden.

Grundsätzlich sei jedoch darauf hingewiesen, dass das Ausmaß der Verbesserung der Dotierstoff-Konzentrationsverteilung mit einem Temperaturunterschied zwischen dem ersten Temperaturbereich T_{I} und dem zweiten Temperaturbereich T_{II} steigt. Ferner sei darauf hingewiesen, dass die Temperatur des ersten Temperaturbereichs T_{I} nicht beliebig weit abgesenkt werden kann, da mit sinkender Temperatur nämlich auch die Reaktionsgeschwindigkeit sinkt und somit das Ausmaß der wesentlichen Vordotierung begrenzt wird. Außerdem übernimmt bei niedrigen Temperaturen mehr und mehr die Gasströmung des Prozessgases eine üblicherweise ungleichmäßige Verteilung des Dotierstoffes im Quarzglasrohr 2, während bei höheren Temperaturen sich der Dotierstoff auf Grund seiner Entropie umso besser verteilt. Der empirisch ermittelte Grenzwert für den ersten Temperaturbereich T_{I} liegt somit oberhalb von 850 °C und vorzugsweise bei ca. 900 °C.

Ferner sei darauf hingewiesen, dass durch die Vordotierung und das nachfolgende Rampen II unter bereits vorliegenden Dotierstoffen in speziellen Fällen sogar mehr Zeit gespart werden kann, als durch die zusätzliche Vordotierung verbraucht wird. In Summe wird das erfindungsgemäße Dotierverfahren in bestimmten Fällen also kürzer.

## Patentansprüche

1. Verfahren zum Dotieren von Halbleiterkörpern mit den Schritten:
a) Vorbereiten einer Diffusionseinrichtung (1) in einem Bereitschafts-Temperaturbereich (T_{B});
b) Einfahren von zu dotierenden Halbleiterkörpern (W) in die Diffusionseinrichtung (1);
c) Erhöhen einer Temperatur der Diffusionseinrichtung (1) bis zu einem ersten Temperaturbereich (T_{I});
d) Belegen der zu dotierenden Halbleiterkörper (W) mit einem Dotierstoff im ersten Temperaturbereich (T_{I});
e) Erhöhen einer Temperatur der Diffusionseinrichtung (1) bis zu einem zweiten Temperaturbereich (T_{II});
f) Belegen der zu dotierenden Halbleiterkörper (W) mit dem Dotierstoff im zweiten Temperaturbereich (T_{II});
g) Eintreiben des Dotierstoffes in das Innere der Halbleiterkörper (W) im oder oberhalb des zweiten Temperaturbereichs (T_{II}) ; und
h) Erniedrigen einer Temperatur der Diffusionseinrichtung (1) bis zum Bereitschafts-Temperaturbereich (T_{B}).

2. Verfahren nach Patentanspruch 1,
**dadurch gekennzeichnet, dass** der erste Temperaturbereich (T_{I}) um eine Temperaturdifferenz von mindestens 50 °C und vorzugsweise von ca. 200 °C unterhalb des zweiten Temperaturbereichs (T_{II}) eingestellt wird.

3. Verfahren nach Patentanspruch 1 oder 2,
**dadurch gekennzeichnet, dass** der erste Temperaturbereich (T_{I}) größer 850 °C und vorzugsweise bei ca. 900 °C eingestellt wird.

4. Verfahren nach einem der Patentansprüche 1 bis 3,
**dadurch gekennzeichnet, dass** der zweite Temperaturbereich (T_{II}) in einem Bereich von 900 bis 1100 °C und vorzugsweise bei ca. 1083 °C eingestellt wird.

5. Verfahren nach einem der Patentansprüche 1 bis 4,
**dadurch gekennzeichnet, dass** der Bereitschafts-Temperaturbereich (T_{B}) unterhalb von 850 °C und vorzugsweise bei ca. 800 °C eingestellt wird.

6. Verfahren nach einem der Patentansprüche 1 bis 5,
**dadurch gekennzeichnet, dass** beim Erhöhen der Temperatur in Schritt e) und/oder beim Belegen in Schritt f) eine Oxidation einer Oberfläche der Halbleiterkörper (W) in der Diffusionseinrichtung (1) durchgeführt wird.

7. Verfahren nach einem der Patentansprüche 1 bis 6,
**dadurch gekennzeichnet, dass** das Dotieren der Halbleiterkörper (W) aus der Gasphase mittels eines Prozessgases (PG) erfolgt.

8. Verfahren nach einem der Patentansprüche 1 bis 7,
**dadurch gekennzeichnet, dass** als Diffusionseinrichtung (1) ein horizontaler Diffusionsofen verwendet wird.

9. Verfahren nach einem der Patentansprüche 1 bis 8,
**dadurch gekennzeichnet, dass** als Halbleiterkörper (W) Silizium-Halbleiterwafer verwendet werden.

10. Verfahren nach einem der Patentansprüche 7 bis 9,
**dadurch gekennzeichnet, dass** als Prozessgas ein Trägergas, ein Reaktionsgas und/oder ein Dotiergas verwendet wird.

11. Verfahren nach einem der Patentansprüche 1 bis 10,
**dadurch gekennzeichnet, dass** das Erhöhen der Temperatur in den Schritten c) und e) mit einer Rate von ca. 8,0 °C/Minute durchgeführt wird.

12. Verfahren nach einem der Patentansprüche 1 bis 11,
**dadurch gekennzeichnet, dass** nach dem Erhöhen der Temperatur in Schritt c) eine Stabilisierung des ersten Temperaturbereichs (T_{I}) durchgeführt wird.

13. Verfahren nach einem der Patentansprüche 1 bis 12,
**dadurch gekennzeichnet, dass** das Belegen in den Schritten d) und f) für ca. 20 Minuten durchgeführt wird.

14. Verfahren nach einem der Patentansprüche 1 bis 13,
**dadurch gekennzeichnet, dass** das Eintreiben in Schritt g) für ca. 60 Minuten durchgeführt wird.

15. Verfahren nach einem der Patentansprüche 1 bis 14,
**dadurch gekennzeichnet, dass** das Erniedrigen der Temperatur in Schritt h) mit einer Rate von ca. - 2,0 °C/Minute durchgeführt wird.

16. Verfahren nach einem der Patentansprüche 1 bis 15,
**dadurch gekennzeichnet, dass** beim Vorbereiten der Diffusionseinrichtung (1) in Schritt a) ein Fluten mit Trägergas und
ein Ausfahren von bereits dotierten Halbleiterkörpern (W) durchgeführt wird.
